# EUROPÄISCHE PATENTSCHRIFT

(11) **EP 4 639 292 B1**
(45) Veröffentlichungstag und Bekanntmachung des Hinweises auf die Patenterteilung: **09.09.2026**
(21) Anmeldenummer: 24707697.9
(22) Anmeldetag: 14.02.2024
(51) Int. Cl.: G05B 13/02

(54) **VERFAHREN UND SYSTEM ZUR OPTIMIERUNG EINES PRODUKTIONSPROZESSES IN EINER TECHNISCHEN ANLAGE**
METHOD AND SYSTEM FOR OPTIMIZING A PRODUCTION PROCESS IN A TECHNICAL INSTALLATION
PROCÉDÉ ET SYSTÈME D'OPTIMISATION D'UN PROCESSUS DE PRODUCTION DANS UNE INSTALLATION TECHNIQUE

(30) Priorität: 23.02.2023 EP 23158366
(43) Veröffentlichungstag der Anmeldung: 29.10.2025
(73) Patentinhaber: Siemens Aktiengesellschaft, 80333 München (DE)
(72) Erfinder: KISSLINGER, Ferdinand, 91217 Hersbruck (DE); AZMOUD, Aziz, 76187 Karlsruhe (DE)
(74) Vertreter: Siemens Patent Attorneys
(86) Internationale Anmeldenummer: PCT/EP2024/053743
(87) Internationale Veröffentlichungsnummer: WO 2024/175442

(56) Entgegenhaltungen:
- EP-A1- 3 696 622
- WO-A1-2022/180120
- US-A1- 2020 074 370

## Beschreibung

Die Erfindung betrifft ein Verfahren und ein entsprechendes System zur Optimierung eines Produktionsprozesses in einer technischen Anlage, in welcher ein verfahrenstechnischer Prozess mit mindestens einem Prozessschritt abläuft. Die Erfindung betrifft ferner ein dazugehöriges Computerprogramm.

Die Verfahrenstechnik beschäftigt sich mit der technischen und wirtschaftlichen Durchführung aller Prozesse, in denen Stoffe oder Rohmaterial nach Art, Eigenschaft und Zusammensetzung verändert werden. Zur Umsetzung eines solchen Prozesses werden verfahrenstechnische Anlagen wie beispielsweise Raffinerien, Steam Cracker oder anderen Reaktoren verwendet, in denen der verfahrenstechnische Prozess zumeist mittels Automatisierungstechnik realisiert wird. Verfahrenstechnische Prozesse werden grundsätzlich in zwei Gruppen aufgeteilt: in kontinuierliche Prozesse und in diskontinuierliche, so genannte Batch-Prozesse. Ein kompletter Produktionsprozess, d. h. ausgehend von bestimmten Edukten bis hin zum fertigen Produkt, kann auch eine Mischung aus beiden Prozessgruppen sein.

Der kontinuierliche Prozess läuft ohne Unterbrechungen ab. Es ist ein Fließprozess, das heißt es gibt einen ständigen Zu- oder Abfluss von Material, Energie oder Information. Kontinuierliche Prozesse werden bei der Verarbeitung großer Mengen mit wenigen Produktwechseln bevorzugt. Ein Beispiel wäre ein Kraftwerk, welches Strom produziert, oder eine Raffinerie, die aus Rohöl Kraftstoffe gewinnt.

Diskontinuierliche Prozesse sind alle Batch-Prozesse, die in chargenorientierter Fahrweise beispielsweise nach ISA-88 nach Rezepten ablaufen. Diese Rezepte enthalten die Information, welche Prozessschritte nacheinander oder auch parallel ausgeführt werden, um ein bestimmtes Produkt mit bestimmten Qualitätsanforderungen herzustellen. Der Einsatz von Material oder Stoffen erfolgt häufig zu unterschiedlichen Zeitpunkten, und zwar portionsweise und nichtlinear im jeweiligen Teilprozess. Dies bedeutet, dass das Produkt durch einen oder mehrere Reaktoren läuft und dort so lange verbleibt, bis die Reaktion abgelaufen ist und der nächste Produktionsschritt oder Prozessschritt vollzogen werden kann. Batch-Prozesse laufen daher grundsätzlich schrittweise mit mindestens einem Prozessschritt ab.

Die Prozessschritte können demnach auf unterschiedlichen Einheiten (physikalische Einrichtungen, in denen der Prozess ausgeführt wird) und/oder mit unterschiedlichen Steuerungsstrategien und/oder unterschiedlichen Mengen ablaufen. Häufig kommen dabei Ablaufsteuerungen (englisch: sequential functional control, abgekürzt SFC) oder auch Schrittketten zum Einsatz.

Im Folgenden wird der Begriff "Batch" als Abkürzung für einen Batch-Prozess mit mindestens einem Prozessschritt verwendet. Nach der ISA-88-Norm handelt es sich bei einem Prozessschritt um die kleinste Einheit eines Prozessmodells. Im Modell der Ablaufsteuerung (vgl. ISA-88) entspricht eine sog. Phase oder Funktion einem Prozessschritt. Solche Phasen können hintereinander (Aufheizen des Reaktors, Rühren innerhalb des Reaktors sowie Abkühlen des Reaktors), aber auch parallel zueinander laufen, wie "Rühren" und "Temperatur konstant halten". In der Regel enthält ein Batch-Prozess mehrere Prozessschritte oder Phasen. Bei der Produktion eines Produktes beispielsweise wird in der Regel jeder Prozessschritt oder jede Phase vielfach durchlaufen (um beispielsweise eine große Menge eines Eduktes herzustellen). Dabei werden die Vielzahl der Durchläufe eines Prozessschritts kennzeichnenden Datensätze mit Werten von Prozessvariablen zeitabhängig erfasst und in einem Datenspeicher abgelegt

In einem idealen Batch-Prozess wird angenommen, dass ein Prozessschritt oder eine Phase unter optimalen Bedingungen im Kontext eines speziellen Rezeptes, mit einer vorgegebenen Kontrollstrategie und in einer bestimmten Teilanlage oder Anlageneinheit abläuft. Es wird ferner erwartet, dass jeder Durchlauf einer Phase (an derselben Stelle im Rezept) von Charge zu Charge gleich ist. Außerdem zeigen alle an der Anlage angeschlossenen Messungen den gleichen Trend (Zeitreihe eines Sensorwertes), beginnend mit der Startzeit der Phase bis zur Endzeit der Phase. Dieses Verhalten kann als "Golden Batch" bezeichnet werden. Ein Golden Batch gibt somit den bisher besten erreichten Produktionszustand in Bezug auf Qualität, Quantität, Laufzeit, sowie geringstmöglicher Abfallmenge an.

In einem realen Batch-Prozess hingegen wird der Betrieb in den verfahrenstechnischen Produktionsanlagen jedoch durch eine Vielzahl von Prozessparametern, Betriebsparametern, Produktionsbedingungen, Anlagenbedingungen und Einstellungen beeinflusst, sodass ein idealer Prozess nur näherungsweise erreicht wird. Faktoren wie Rauschen in den Sensormesswerten, Umgebungsbedingungen (z. B. die Außentemperatur), Qualität der Edukte, Ausrüstungsmängel (z. B. Verstopfung eines Ventils) oder Ausfälle von Geräten führen zu erhöhten Kosten beim Produktionsprozess, zu Qualitätseinbußen bei den Produkten und Verzögerungen beim Produktionsprozess, um nur einige negative Auswirkungen zu nennen. Daher ist es wichtig, die Probleme in einer Batch Produktion möglichst frühzeitig zu erkennen und die Ursache möglichst schnell zu identifizieren, um Korrekturen am Prozess vornehmen zu können.

Eine gängige Methode zur Erkennung von Problemen in Batch-Prozessen ist die Überwachung der Prozesswerte anhand von Alarmschwellen. Wird ein Schwellenwert für einen bestimmten Prozesswert verletzt, wird der Betreiber einer Anlage vom Prozessleitsystem benachrichtigt. Das Einstellen dieser Schwellenwerte ist sehr aufwändig und außerdem können multivariate Abweichungen innerhalb der univariaten Schwellenwerte nicht erkannt werden.

Eine zweite Möglichkeit, Probleme bei Batch-Prozessen zu erkennen, ist die Auswertung der Labormessungen des fertigen Produkts. Liegt eine Labormessung außerhalb der Qualitätsspezifikationen, können die Verfahrenstechniker die Trenddaten der entsprechenden Chargenphasen überprüfen. Schließlich ist es die Aufgabe der Prozessexperten, die Ursache eines bestimmten Problems zu ermitteln und Maßnahmen einzuleiten, um das Problem zu lösen und es in Zukunft zu vermeiden. Dieser Ansatz der Ursachenermittlung ist sehr kostenintensiv und erfordert qualifizierte und erfahrene Prozessexperten. Ein weiterer Nachteil ist, dass, falls das Problem aufgrund einer Labormessung außerhalb des Prozesses entdeckt wird, es bereits eine Zeitverzögerung zwischen der Phase, in der das Problem entdeckt wurde, und der aktuellen Phase der Produktion gibt. Dies bedeutet, dass Produktionsprobleme häufig erst zu spät und im Nachhinein entdeckt werden.

Eine online-Überwachung des Prozessverhaltens oder zumindest eine deutlich schnellere Analyse von Problemen bei der Batch-Produktion wird mittels datengetriebener oder modellbasierter Verfahren erreicht. Eine physikalische Modellierung der häufig sehr komplexen nichtlinearen dynamischen Prozesse ist allerdings sehr aufwändig und benötigt in der Regel recht hohe Rechnerkapazitäten. Datengetriebene Verfahren mittels künstlicher Intelligenz (KI) erlauben hingegen, eine große Menge an Prozessdaten (viele Phasendurchläufe und viele Prozessvariablen) schnell und einfach zu analysieren. Anomalien sind einfach erkennbar, wenn die künstliche Intelligenz mit so genannten Gut-Daten trainiert wurde. Allerdings ist es nicht einfach, die großen Datenmengen zu interpretieren und entsprechend ihrem Kontext einzuordnen. Problematisch wird es dann, wenn Nicht-Prozessdaten den Produktionsprozess beeinflussen, wie beispielsweise die Umgebungstemperatur oder die Qualität der Ausgangsstoffe. Eine potenziell große Menge an multivariaten Prozessdaten ist in der Regel nicht interpretierbar, was allerdings die Ursachenbestimmung bei auftretenden Problemen im Produktionsprozess stark vereinfachen würde. Durch eine verbesserte Analyse des Kontextes des Prozesses würde nicht nur eine Fehleranalyse, sondern auch ein verbessertes Verständnis für den Produktionsprozess im Allgemeinen erreicht werden.

Eine weitere Möglichkeit, Probleme bei Batch-Prozessen zu erkennen ist die Nutzung von KI und digitalen Zwillingen technischer Anlagen. Aus der EP 3 696 622 A1 ist ein Ansatz bekannt, bei dem ein digitaler Zwilling einer technischen Anlage auf Basis strukturierter "Smart Data Tags" erstellt wird. Diese Tags verknüpfen Automatisierungs- und Mechanikmodelle und dienen als direkte Schnittstelle für KI-Systeme. Dabei wird beschrieben, dass KI-Analysen genutzt werden, um Beziehungen zwischen Prozessvariablen und Leistungskennzahlen (KPIs) zu identifizieren und diese Informationen in den Smart Tags zu speichern. Der Fokus liegt hierbei auf einer KIbasierten Validierung des digitalen Zwillings sowie einer durch Kontextualisierung beschleunigten Datenanalyse.

Es ist daher die Aufgabe der vorliegenden Erfindung, für Batch-Prozesse ein datenbasiertes, einfaches Verfahren und System zur Optimierung des Produktionsprozesses anzugeben, welches insbesondere für einen Anwender des Verfahrens auf einfache Art und Weise erlaubt, das generelle Prozessverhalten besser zu verstehen und darauf basierend weitere Analysen des Produktionsprozesses durchzuführen. Davon ausgehend liegt der Erfindung die Aufgabe zugrunde, ein geeignetes Computerprogramm, insbesondere eine Softwareapplikation, anzugeben.

Diese Aufgabe wird durch die Merkmale des unabhängigen Patentanspruchs 1 gelöst. Außerdem wird die Aufgabe gelöst durch ein System nach Anspruch 11 und ein Computerprogramm nach Anspruch 13.

Ausgestaltungen der Erfindung, die einzeln oder in Kombination miteinander einsetzbar sind, sind Gegenstand der Unteransprüche.

Es ist bekannt, dass Clustering bei der Datenanalyse zu Erkenntnisgewinnung und Mustererkennung benutzt werden kann, um mehr über die untersuchte Datendomäne zu erfahren. Die Grundidee der vorliegenden Erfindung besteht nun darin, durch die Verknüpfung einer datengetriebenen Gruppierung von multivariaten Zeitreihendaten vieler Durchläufe von Batch-Prozessschritten mit einer Kennzeichnung durch Metadaten weitergehende Aussagen und Analysen über den Produktionsprozess zu erhalten, um so den Produktionsprozess besser zu verstehen und zu optimieren.

Die Erfindung betrifft demnach ein Verfahren zur Optimierung eines Produktionsprozesses in einer technischen Anlage, in welcher ein verfahrenstechnischer Prozess mit mindestens einem Prozessschritt abläuft, wobei eine Vielzahl von Datensätzen von Durchläufen eines Prozessschritts mit Werten von Prozessvariablen zeitabhängig erfasst und in einem Datenspeicher abgelegt werden. Erfindungsgemäß werden zunächst ein zu untersuchender Prozessabschnitt des verfahrenstechnischen Prozesses und die zu untersuchenden Prozessvariablen ausgewählt. Für diesen Prozessabschnitt und die ausgewählten Prozessvariablen werden anschließend die historischen Datensätze der zugehörigen Durchläufe ausgewählt. Die derart erhaltenen Zeitserien werden mittels eines Machine Learning (abgekürzt ML) Verfahrens zu Clustern zusammengefasst. Die zu den erhaltenen Clustern zugehörigen Zeitserien werden gemäß ihrer Zugehörigkeit visualisiert, die einzelnen Cluster gekennzeichnet und mit Metadaten verknüpft. Die gekennzeichneten und mit Metadaten verknüpften Cluster können zur Optimierung des Produktionsprozesses verwendet werden.

Die Vorteile des erfindungsgemäßen Verfahrens sind vielfältig. Der größte Vorteil besteht darin, dass eine potenziell große Menge an multivariaten Prozessdaten durch das erfindungsgemäße Verfahren auf Gruppen oder Cluster von Phasenläufen mit ähnlichem Verhalten reduziert wird. Dies erfolgt automatisiert mittels eines ML Algorithmus. Ein Anwender des erfindungsgemäßen Verfahrens hat die Möglichkeit, die mittels des ML Modells gefundenen Cluster durch verschiedene Darstellungen und durch Verknüpfung mit Metadaten zu untersuchen. Die Verknüpfung kann dabei manuell (durch den Anwender selbst) oder automatisch durch einen geeigneten Algorithmus erfolgen. Die Untersuchungsdauer, d.h. der Zeitabschnitt des Prozesses, der untersucht werden soll (der Prozessabschnitt), ist dabei vorteilhaft frei wählbar. Es ist nicht zwingend notwendig, dass der zu untersuchende Prozessabschnitt mit einem Prozessschritt oder einer Phase zusammenfallen muss. Der Prozessabschnitt kann auch phasenübergreifend ausgewählt werden. Im Allgemeinen umfasst ein Prozessabschnitt eine fest bestimmte Zeitdauer des verfahrenstechnischen Prozesses mit einem definierten Zeitanfang und -ende.

Dabei können die Cluster in besonders vorteilhafter Weise in einer Benutzeroberfläche beispielsweise als Bänder visualisiert werden. Ein Anwender hat die Möglichkeit, die Cluster über Kommentare oder verschiedene Kategorisierungen zu kennzeichnen und zu kontextualisieren. Das Kennzeichnen der Cluster kann sowohl manuell, also auch automatisch durch einen geeigneten Algorithmus erfolgen. Es können jegliche Metadaten hinterlegt werden, wie beispielsweise die Ursachen von aufgetretenen Problemen, Hinweise für Lösungswege/Korrekturen, oder eine Bewertung, wie kritisch Prozessverhalten, welches sich im Verhalten des Clusters widerspiegelt, im untersuchten Prozessabschnitt ist. Ferner erhält der Anwender Aufschluss darüber, welche historischen Phasenverläufe in einem Cluster zusammengefasst wurden und wie das Verhalten des Clusters sich über die Zeit entwickelt. Ein Anwender erhält so einen tieferen Einblick in das Prozessverhalten, insbesondere, wenn sehr viele Phasendurchläufe zu einem Cluster zusammengefasst sind. Handelt es sich bei einem gekennzeichneten Cluster beispielsweise um einen Prozessschritt, der eine gute Qualität der Produkte ergibt (beispielsweise ein synthetischer Stoff mit hoher Reinheit), so können die eingestellten Regel- und Bedienparameter dieses Prozessabschnitts reproduziert werden, um die Produktion zu optimieren.

In einer besonders vorteilhaften Variante des erfindungsgemäßen Verfahrens kann für einen neuen Datensatz des Batch-Prozesses (multivariate Zeitseriendaten der Prozessvariablen) eine Zeitserie eines Prozessabschnitts ausgewählt werden und überprüft werden, zu welchem Cluster der zu untersuchende Datensatz gehört. Dabei muss es sich nicht um einen aktuellen Datensatz handeln. Auch die Untersuchung historischer Datensätze ist möglich. "Neu" bedeutet in diesem Zusammenhang, dass der Datensatz bisher noch nicht von einer Clusterung mittels des zuvor verwendeten ML-Verfahrens umfasst war.

In dieser Ausführungsvariante wird für mindestens eine Prozessvariable ein neuer Datensatz eines Prozessabschnitts mittels einer auf das Cluster-Verfahren angepassten Metrik überprüft, ob oder wie gut die Werte des Datensatzes einem zuvor gekennzeichneten Cluster zugeordnet werden können. Nach der erfolgten Zuordnung des Datensatzes zu einem oder mehreren Clustern werden dem Anwender zumindest Teile von zuvor mit dem Cluster hinterlegten Metadaten ausgegeben, welche nicht nur zur Optimierung des Produktionsprozesses, sondern auch zur Überwachung des Produktionsprozesses verwendet werden können. Die hinterlegten Metadaten können von einem Anwender zur Bewertung oder Korrektur insbesondere des aktuellen Prozesses genutzt werden. Wenn die neuen Daten der Batch-Phase zu einem Cluster passen, kann ein Anwender beispielsweis benachrichtigt werden, dass ein bestimmtes Prozessverhalten gefunden wurde. Im Falle der Analyse historischer Daten kann dem Anwender eine Zusammenfassung des im Zusammenhang mit dem Cluster gefundenen Prozessverhaltens zur Verfügung gestellt werden. Die Zuordnung zu einem Cluster von Phasenläufen bietet auch den Vorteil, dass der Cluster auch die Variation der Messdaten für dieses Prozessverhalten berücksichtigt. Die Wahrscheinlichkeit einer erfolgreichen Zuordnung kann sich damit, im Vergleich zu einer paarweisen Ähnlichkeitsbestimmung der Phasen, erhöhen. Im Falle einer automatisierten Zuordnung, können somit vorteilhaft sehr schnell Aussagen zu einem aktuellen Prozessverhalten getroffen werden.

In einer weiteren vorteilhaften Ausführungsvariante wird die Metrik zur Zuordnung des neuen Datensatzes zu einem Cluster mittels eines Anpassungsfaktors berechnet wird, wobei zunächst die Breite und der Mittelwert eines betrachteten Clusterbandes bestimmt wird. Anschließend werden pro Zeitstempel des neuen Datensatzes eine skalierte Abweichung (= Distanz zum Mittelwert des Clusterbandes skaliert mit der entsprechenden Bandbreite) bestimmt und für alle Zeitstempel des neuen Datensatzes eine Anzahl der skalierten Abweichungen und Abweichungsstärke bestimmt, die eine bestimmte Größe der skalierten Abweichungen überschreiten. Auch die unterschiedlichen Laufzeiten der Zeitserien des Clusters im Vergleich zur Laufzeit des neuen Datensatzes werden berücksichtigt. Der Faktor sollte 100% betragen, wenn für alle Zeitstempel alle Werte der Prozessvariablen des Datensatzes innerhalb des Clusterbandes liegen. Mittels des Anpassungsfaktors kann die Zuordnung eines neuen Datensatzes zu einem Cluster vorteilhaft quantifiziert werden. Die Güte und die Genauigkeit der Prozessüberwachung können auf diese Weise signifikant erhöht werden.

In einer weiteren Ausführungsvariante werden vorteilhaft Ausreißer gefiltert, indem die skalierten Abweichungen entlang der Zeitachse geglättet werden. Dies wäre beispielsweise durch einen Median-Filter realisierbar, der sich entlang der Zeitachse bewegt und statt einzelner Messwerte eine Vielzahl von Messwerten berücksichtigt, was insbesondere bei Sensoren mit hohem Rauschen günstig ist.

Das erfindungsgemäße Verfahren der Zuordnung eines neuen Datensatzes zu mindestens einem Cluster mit seinen Ausführungsvarianten ist vorteilhaft während des laufenden Betriebs einer technischen Anlage einsetzbar und kann optional auch in Echtzeit durchgeführt werden. Während das Cluster-Analyse-Verfahren durch das Auswählen bestimmter Durchläufe und Prozessvariablen, das Clustern und Kennzeichnen nur bedingt als Online-Verfahren im laufenden Betrieb geeignet ist, kann eine Zuordnung neuer Datensätze zu den zuvor abgespeicherten Clustern deutlich schneller erfolgen, da die Cluster bereits vorhanden sind und die Berechnung des Anpassungsfaktors automatisiert erfolgen kann. Sobald dem Anwender die Zeitseriendaten mindestens einer Prozessvariablen von einem Prozessabschnitt vorliegt, kann überprüft werden, ob die Zeitserie einem Cluster zuordenbar ist. Der Anwender erhält somit sehr schnell eine Aussage über das Prozessverhalten. Mittels der Metadaten des gefundenen Clusters kann der laufende Betrieb ggfs. beeinflusst werden, indem Regelparameter oder Sollwerte modifiziert werden oder Prozessvariablen (wie Temperatur in einem Reaktor, Druck oder Füllstand) angepasst werden.

In einer besonders vorteilhaften Ausführungsvariante kann im laufenden Betrieb die Zuordnung eines neuen Datensatzes zu einem Cluster angestoßen oder getriggert werden, wenn eine bestimmte Bedingung erfüllt ist. Besonders vorteilhaft erweist sich, die Cluster-Zuordnung einzuleiten, wenn die Laufzeit des neuen Datensatzes mindestens einem vorbestimmten Bruchteil des Medians der Laufzeiten der Zeitserien des Clusters entspricht. Ein Anwender kann somit vorgeben, wann die eine Auswertung sinnvoll ist. Alternativ kann der Trigger auch automatisiert gesetzt werden. Wenn die neuen Daten der Batch-Phase zu einem Cluster passen, und ein Anwender wiederholt benachrichtigt wird, dass ein bestimmtes Prozessverhalten gefunden wurde, lässt sich durch den Trigger verhindern, dass ein Anwender zu viele Notifizierungen erhält. In Summe erlaubt die Triggerfunktion eine flexiblere Handhabung der Cluster-Zuordnung.

In weiteren vorteilhaften Ausführungsvarianten kann der Prozessabschnitt gemäß einer Logik oder datengetrieben, insbesondere basierend auf Daten des Produktionsprozesses, z.B. durch Zeitreihensegmentierung, ausgewählt werden. Die Logik kann dabei beispielsweise auf der Realisierung des Batch Prozesses in einem Automatisierungssystem oder einer Steuerung basieren. Alternativ können bestimmte Prozessschritte (z.B. "Nur für das Aufheizen eines Reaktors soll eine Cluster-Analyse durchgeführt werden") oder zum Beispiel kritische Zeitabschnitte im Laufe eines Prozesses durch einen Anwender oder einen Algorithmus vorgegeben werden. Dies erlaubt vorteilhaft eine flexible und an die jeweilige Situation und Anlage angepasste Cluster-Analyse.

Die Zusammenfassung der Vielzahl von Zeitreihen der Phasendurchläufe zu Clustern erfolgt mittels Verfahren des maschinellen Lernens. Dies bedeutet, dass die Cluster oder Gruppen nicht wie bei der Klassifizierung aufgrund vorgegebener gemeinsamer Merkmale gebildet werden, sondern dass die Gruppen oder Cluster aufgrund einer räumlichen Abstandsmetrik der Vektoren (hier der Zeitseriendaten) zusammengefasst werden. Grundsätzlich gibt es verschiedene Verfahren, diesen Abstand zu bestimmen wie die euklidische oder die Minkowski-Metrik. Zusätzlich ist in diesem Anwendungsfall noch zu beachten, dass es sich um multivariate Zeitserien unterschiedlicher Länge handelt. Daher können auch so genannte Dynamic Time Warping-Verfahren zur Anwendung kommen. Die Verwendung von Abstandsmetriken für Zeitseriendaten für das Clustering stellt die genaueste Vergleichsmöglichkeit dar, allerdings führt dies auch zu großer Sensitivität beispielsweise in Bezug auf das Rauschen der gemessenen Prozesswerte. Es gibt Fälle, in denen es vorteilhaft ist, die Robustheit des Verfahrens, z.B. gegenüber dem Rauschen der Messwerte, zu erhöhen. In diesen Fällen ist es vorteilhaft, robustere Merkmale zu verwenden. Dabei kann es sich entsprechend einer Ausführungsvariante um statistische Merkmale handeln, wie Mittelwert, Standardabweichung oder Schiefe der Verteilung der Sensordaten (Prozessvariablen). Entsprechend einer weiteren Ausführungsvariante werden datengetrieben Merkmale der Zeitserien, z.B. die latente Repräsentation eines Autoencoders, der auf den Daten des Prozessabschnittes trainiert wurde, berechnet. Beide Varianten zeichnen sich ebenfalls durch eine hohe Robustheit und Effizienz aus.

Die zuvor formulierte Aufgabe wird ebenfalls gelöst durch eine Verwendung des Verfahrens mit all seinen Varianten, wie zuvor erläutert, zum Labelling von Gruppen von Datensätzen, insbesondere von Zeitreihendaten. Liegen geclusterte Daten bestehend aus Zeitreihendaten bereits vor, so kann ein Anwender diese durch die Kennzeichnung mit Metadaten mit so genannten Labels versehen. Aus dem nichtüberwachten Verfahren des maschinellen Lernens könnte auf diese Weise vorteilhaft ein überwachtes Verfahren ableitbar sein. Dazu würden die einzelnen Cluster, die ja einzeln ausgewertet und gekennzeichnet sind und demnach gelabelten Datensätzen entsprechen, einem Klassifizierungsverfahren zur Verfügung stehen. Darauf basierend sind weitere Datenanalysen möglich. Ein weiterer Vorteil ist, dass die Metadaten als Bezeichner (Labels) für das Trainieren des Machine Learning Algorithmus verwendet werden können, z.B. um die meist hohe Anzahl der "guten" Durchläufe mit der geringen Anzahl von Fehlern oder "schlechten" Durchläufe auszugleichen.

Die zuvor formulierte Aufgabe wird ferner gelöst durch eine Verwendung des Verfahrens mit all seinen Varianten wie zuvor erläutert zur Ursachenanalyse von auftretenden Problemen beim Produktionsprozess in einer technischen Anlage. Es handelt sich dabei um eine besonders einfache, aber sehr effiziente Art der Ursachenanalyse, wenn die Metadaten eine hohe Qualität aufweisen. Umfassen die Metadaten, welche mit einem Cluster verknüpft sind, eine ausführliche und gewissenhafte Dokumentation des historischen Prozessverhaltens durch einen Experten, so kann dieses Wissen bei der Problemidentifikation und -lösung sehr wertvoll sein.

Die zuvor ausgeführte Aufgabe wird ferner durch ein System zur Optimierung des Produktionsprozesses in einer technischen Anlage gelöst. Bei dem Begriff System kann es sich sowohl um ein Hardwaresystem wie einem Computersystem bestehend aus Servern, Netzwerken und Speichereinheiten als auch um ein Softwaresystem wie einer Softwarearchitektur oder ein größeres Softwareprogramm handeln. Auch eine Mischung aus Hardware und Software ist denkbar, beispielsweise eine IT-Infrastruktur wie eine Cloud-Struktur mit ihren Services. Bestandteile einer solchen Infrastruktur sind üblicherweise Server, Speicher, Netzwerke, Datenbanken, Software-Anwendungen und -dienste, Datenverzeichnisse und Datenverwaltungen. Insbesondere virtuelle Server gehören ebenso zu einem System dieser Art.

Das erfindungsgemäße System kann auch Teil eines Computersystems sein, welches sich räumlich getrennt vom Standort der technischen Anlage, befindet. Das angeschlossene externe System, weist dann vorteilhaft Komponenten auf, die ausgebildet sind, das erfindungsgemäße Verfahren durchzuführen. Auf diese Weise kann zum Beispiel eine Kopplung mit einer Cloud-Infrastruktur erfolgen, was weiterhin die Flexibilität der Gesamtlösung erhöht.

Auch lokale Implementierungen auf Computersystemen der technischen Anlage können vorteilhaft sein. So ist eine Implementierung z.B. auf einem Server des Prozessleitsystems oder on premise, d.h. innerhalb einer technischen Anlage insbesondere für sicherheitsrelevante Prozesse besonders geeignet.

Das erfindungsgemäße Verfahren wird somit bevorzugt in Software oder in einer Kombination Soft-/Hardware implementiert, so dass die Erfindung auch ein Computerprogramm, insbesondere eine Software-Applikation, mit durch einen Computer ausführbaren Programmcodeanweisungen zur Implementierung des Verfahrens betrifft. Ein solches Computerprogramm kann, wie oben beschrieben, in einen Speicher eines Servers z.B. eines Prozessleitsystems geladen werden, so dass die Überwachung des Betriebs der technischen Anlage automatisch durchgeführt wird, oder das Computerprogramm kann bei einer Cloudbasierten Überwachung einer technischen Anlage in einem Speicher eines Remote-Service-Rechners vorgehalten oder in diesen ladbar sein.

Im Folgenden wird die Erfindung anhand der Figuren und anhand eines Ausführungsbeispiels näher beschrieben und erläutert.

Es zeigen
Figur 1 ein Beispiel für datengetriebene Gruppierungen von multivariaten Zeitreihendaten von Durchläufen eines Batch-Prozessabschnitts
Figur 2 eine schematische Darstellung zur Veranschaulichung des erfindungsgemäßen Verfahrens der Cluster-Analyse
Figur 3 eine schematische Darstellung zur Veranschaulichung des erfindungsgemäßen Verfahrens der Zuordnung eines Datensatzes einer Zeitreihe zu den vorhandenen Clustern
Figur 4 ein Beispiel eines zur Durchführung des erfindungsgemäßen Verfahrens geeigneten Systems

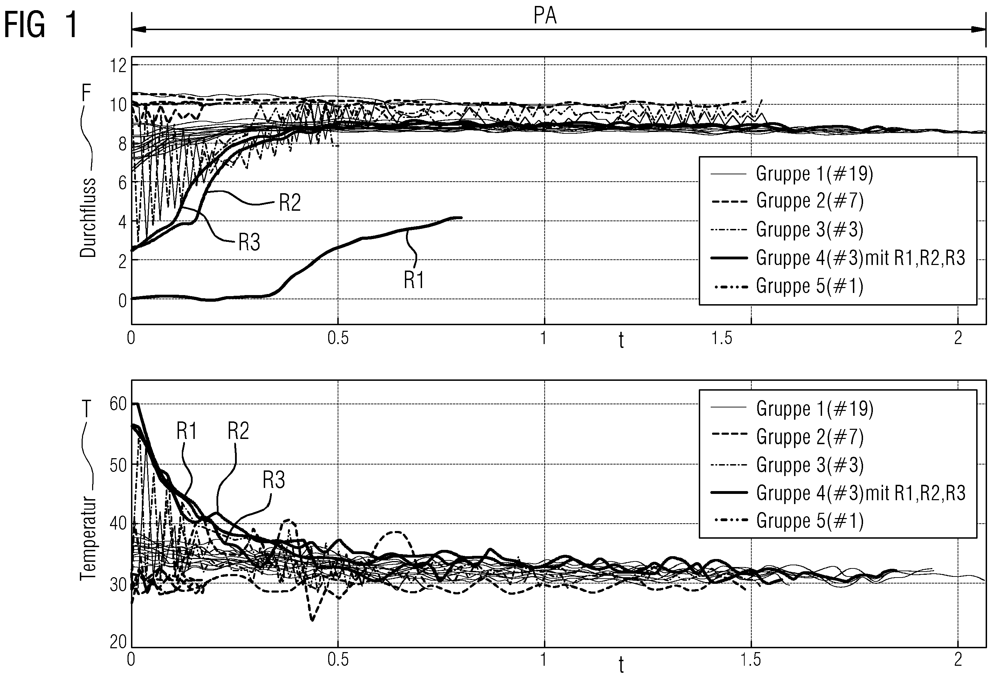

In Fig. 1 ist gemäß einer ersten Ausführung der Erfindung beispielhaft für zwei Prozessvariablen das Ergebnis von Gruppierungen von Zeitserien einer Vielzahl von Datensätzen von Durchläufen eines Batch-Prozessabschnitts dargestellt. Bei den Zeitserien handelt es sich um Trends oder Zeitreihen unterschiedlicher Durchläufe der gezeigten Prozessvariablen Durchfluss F und Temperatur T, deren Werte gegen die Zeit t aufgetragen sind. Das gezeigte Zeitfenster entspricht hier einem Prozessabschnitt PA. Pro Prozessvariable sind jeweils 5 Gruppen oder Cluster (Gruppe 1 bis Gruppe 5) dargestellt. Die die zu den erhaltenen Clustern zugehörigen Zeitserien sind gemäß ihrer Zugehörigkeit in diesem Ausführungsbeispiel durch die Linienart gekennzeichnet. Die Visualisierung gemäß der Zugehörigkeit zu Clustern ist beliebig wählbar. Die Gruppe 1 umfasst jeweils die Zeitreihendaten von 19 Durchläufen der entsprechenden Prozessvariablen. Die Gruppe 2 umfasst die Zeitserien von 7 Durchläufen, Gruppe 3 umfasst die Zeitserien von 3 Durchläufen, Gruppe 4 umfasst die Zeitserien von 3 Durchläufen und Gruppe 5 umfasst eine einzelne Zeitserie eines Durchlaufs (welche allerdings nicht erkennbar ist). Für die Gruppe 4 sind in der Figur für die gezeigten Prozessvariablen T und F die Datensätze der einzelnen Durchläufe R1, R2 und R3 markiert. Die einzelnen Cluster werden in der Regel unabhängig voneinander gespeichert.

Der Begriff der Zeitserie wird in diesem Kontext derart verwendet, dass Daten nicht kontinuierlich, sondern diskret (zu bestimmten Zeitstempeln), aber in endlichen zeitlichen Abständen aufgenommen werden. Zur Überwachung des Betriebs einer verfahrenstechnischen Anlage wird eine Vielzahl von Datensätzen von Prozessvariablen, die den Betrieb der Anlage kennzeichnen, in Abhängigkeit von der Zeit t erfasst und in einem Datenspeicher (häufig ein Archiv) abgespeichert. Zeitabhängig bedeutet hier folglich entweder zu bestimmten einzelnen Zeitpunkten mit Zeitstempeln oder mit einer Abtastrate in regelmäßigen Abständen oder auch annähernd kontinuierlich. In den Datensätzen eines Durchlaufs R1 sind somit n Werte der jeweiligen Prozessvariablen mit den jeweiligen Zeitstempeln umfasst, wobei n eine beliebige natürliche Zahl darstellt. Prozessvariablen werden in der Regel mittels Sensoren erfasst. Beispiele für Prozessvariablen sind Temperatur T, Druck P, Durchfluss F, Füllstand L, Dichte oder Gaskonzentration eines Mediums.

Der Startzeitpunkt jedes Prozessschritts oder Phase ist mit t = 0 bezeichnet. In Fig. 1 ist bei Vergleich der multivariaten Daten der vielen Durchläufe deutlich erkennbar, dass es Unterschiede bei den Laufzeiten der Zeitserien gibt. Die unterschiedlichen Laufzeiten können sowohl beim Clustering-Verfahren, als auch bei der Zuordnung eines neuen Datensatzes eines Durchlaufs zu einzelnen Clustern berücksichtigt werden.

Der Begriff des Prozessabschnitts ist erfindungsgemäß derart gewählt, dass er einen beliebigen Zeitabschnitt des Batch-Prozesses umfasst. Ein Prozessabschnitt kann einer Dauer einer Batch-Phase entsprechen, kann aber auch nur ein Bruchteil davon ausmachen. Es kann sich auch um phasenübergreifende Zeitabschnitte handeln, oder auch mehrere Phasen umfassen. Ein Prozessabschnitt entspricht demnach einem beliebig wählbaren Zeitabschnitt des verfahrenstechnischen Prozesses mit einem festen Anfangszeitpunkt t0 und festen Endzeitpunkt tend. Er sollte definierbar und wiederholbar sein.

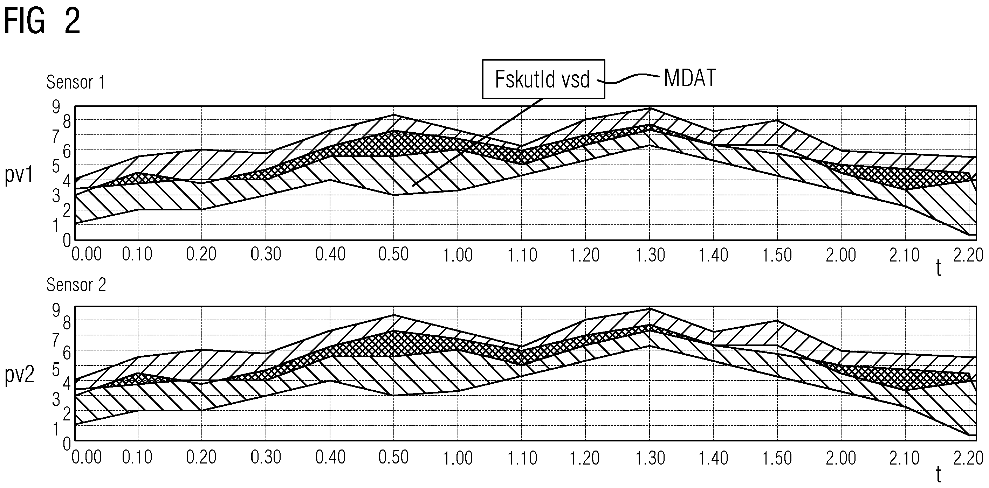

Ein Anwender hat nun die Möglichkeit, die gefundenen Cluster durch verschiedene Darstellungen oder Visualisierungen und durch Verknüpfung mit Metadaten zu untersuchen. In Fig. 2 ist beispielsweise eine schematische Darstellung für eine Visualisierung der einzelnen Gruppen oder Cluster durch Bänder gezeigt. Die zu den erhaltenen Clustern zugehörigen Zeitserien sind demnach gemäß ihrer Zugehörigkeit zu Clusterbändern zusammengefasst. Gezeigt sind die Clusterbänder für 2 Prozessvariablen pv1 und pv2, welche jeweils mit den entsprechenden Sensoren aufgenommen wurden. Ein Band ist in diesem Ausführungsbeispiel derart gewählt, dass pro Zeitstempel alle Minima und Maxima der Werte der Prozessvariablen des Clusters die Ober- bzw. Untergrenze des Bandes definieren. Ein Anwender hat nun die Möglichkeit, die Cluster zu kennzeichnen oder zukontextualisieren, unter anderem über Kommentare oder verschiedene Kategorisierungen. So können mit einem Cluster z.B. folgende Metadaten MDAT hinterlegt werden:
- Ursachen für Probleme.
- Eine Bewertung, wie kritisch das mit dem Cluster im Zusammenhang stehende Prozessverhalten ist.
- Hinweise für Lösungswege/Korrekturen.
- Ansprechpartner.

Die Kennzeichnung der Cluster mit Metadaten wird in der Regel manuell durch den Eintrag des Anwenders erfolgen. Die Verknüpfung der Metadaten jedoch kann auch automatisch verfolgen, wenn beispielsweise bestimmte Merkmale der Cluster einen Automatismus auslösen, dass eine Information mit dem Cluster in Verbindung gebracht werden soll.

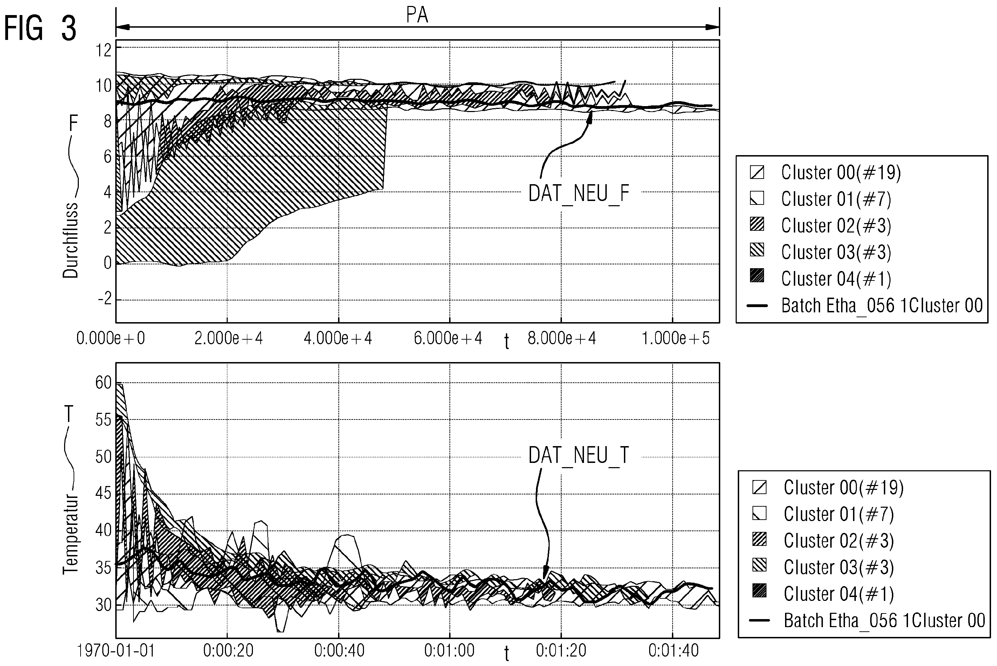

Ein Anwender kann einzelne Cluster aus einer oder mehreren Cluster-Analyse(n) auswählen, um diese für die Überwachung von neuen Online-Daten oder zur Anwendung auf andere historische Daten zu nutzen. Diese Ausführungsvariante des erfindungsgemäßen Verfahrens wird anhand von Figur 3 deutlich.

In Fig. 3 sind die Gruppen oder Cluster aus Fig. 1 als Bänder visualisiert. Die Gezeigten Graphen sind beispielsweise im Dashboard einer Software-Applikation dargestellt. Ein Anwender erhält nun aus dem laufenden Betrieb einer verfahrenstechnischen Anlage jeweils neue Datensätze DAT_NEU_F und DAT_NEU_T von Durchläufen der dargestellten Prozessvariablen des Durchflusses F und der Temperatur T für den zuvor ausgewählten Prozessabschnitt PA. Der Anwender kann nun pro Prozessvariable eine Zuordnung des neuen Datensatzes zu einem der gezeigten Cluster anstoßen. Denkbar wäre auch eine Zuordnung zu irgendeinem zuvor für die entsprechende Prozessvariable abgespeichertem Cluster.

Der Zuordnungsalgorithmus basiert auf einem auf das Cluster-Verfahren angepassten Metrik und überprüft, ob oder wie gut die Werte des neuen Datensatzes einem zuvor gekennzeichneten Cluster zugeordnet werden können. Nach erfolgter Zuordnung des Datensatzes zu einem oder mehreren Clustern können zumindest Teile von zuvor mit dem Cluster hinterlegten Metadaten ausgegeben und zusätzlich zur Überwachung des Produktionsprozesses verwendet werden. Die Kontextualisierung bietet den Vorteil, dass dem Nutzer direkt ein Optimierungs- /Lösungsvorschlag angeboten werden kann, wenn eine Übereinstimmung mit einem entsprechenden Cluster gefunden wird. Da die Cluster und die zugehörigen Metadaten unabhängig von der Cluster-Analyse und selektiv (d.h. nur ein Teil der Cluster) überwacht und gepflegt werden können, bietet das Verfahren die Möglichkeit, nur die gespeicherten Cluster (ggfs. auch mit den zugehörigen Metadaten) zu behalten, die für die Zukunft eine Relevanz besitzen. Somit können z.B. Sonderfälle von Phasenläufen oder ungewöhnliches Verhalten, welches in der Vergangenheit aus bekannten Gründen aufgetreten ist (z.B. der Reaktor musste im Mai mit einer anders dimensionierten Ersatzpumpe betrieben werden.), ausgeschlossen werden. Zusätzlich kann auf diese Weise die Zahl der nutzlosen Notifizierungen reduziert werden.

Zur Durchführung einer solchen robusten Ursachenanalyse kann einem Anlagenbetreiber oder einem Prozessingenieur für den neuen Datensatz unterschiedlichste Informationen in Kombination mit dem zugeordneten Cluster angezeigt werden. Der genaue Inhalt der Metadaten kann ferner für jeden Anwendungsfall konfiguriert werden. Schließlich ist zu beachten, dass die Metadaten aus unterschiedlichen Informationsquellen stammen können und der Zugriff darauf entweder manuell oder automatisch erfolgen kann.

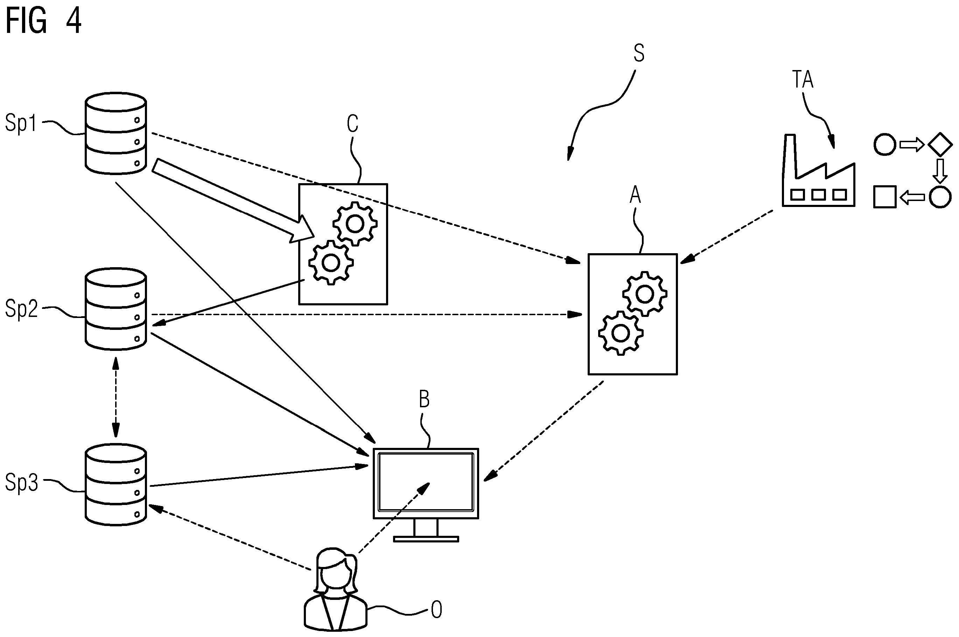

In diesem Zusammenhang wird auf Figur 4 verwiesen. Dort ist ein Ausführungsbeispiel für ein System S gezeigt, welches derart ausgebildet ist, das erfindungsgemäße Verfahren durchzuführen. Das System S umfasst in diesem Ausführungsbeispiel drei Einheiten zum Speichern von Daten. Je nach Ausführung sollte mindestens ein Datenspeicher vorhanden sein. Bei mehr als einem Datenspeicher kann eine beliebige Verteilung der zu speichernden Daten vorgesehen werden. Datenspeicher Sp1 enthält in diesem Ausführungsbeispiel eine Vielzahl von historischen Datensätzen mit den multivariaten Trends der Phasen- Durchläufe. Alle historischen Datensätze, Datensätze, die Werte von einer Vielzahl von Prozessvariablen mit entsprechenden Zeitstempeln enthalten, können für das ML Modells zur Clusterung verwendet werden.

Für die Durchführung der Clusterung der vielen Datensätze von Durchläufen der einzelnen Prozessvariablen, welche in diesem Ausführungsbeispiel in der Recheneinheit C erfolgt, ist die Recheneinheit C mit der Speichereinheit Sp1 verbunden. In einer besonders vorteilhaften Ausführung ist die Recheneinheit C Teil einer übergeordneten Auswerteeinheit (nicht dargestellt). Denkbar sind jeweils unterschiedliche Einheiten oder nur eine Einheit in Form eines Servers, auf dem eine Applikation mit allen Funktionen der Berechnung und Auswertung implementiert ist. Die Auswerteeinheit und/oder die Recheneinheit C kann ferner mit einem Leitsystem einer technischen Anlage TA oder einem Rechner einer technischen Teilanlage, in welchen ein verfahrenstechnischer Prozess mit mindestens einem Prozessschritt abläuft, über eine Kommunikationsschnittstelle verbunden sein, über welche (z.B. auf Anfrage) die multivariaten Datensätze der Phasen-Durchläufe übermittelt werden. In der technischen Anlage TA steuert, regelt und/oder überwacht ein Automatisierungssystem oder ein Prozessleitsystem einen verfahrenstechnischen Prozess. Dazu ist das Prozessleitsystem mit einer Vielzahl von Feldgeräten (nicht dargestellt) verbunden. Messumformer und Sensoren dienen zur Erfassung von Prozessvariablen, wie beispielsweise Temperatur T, Druck P, Durchflussmenge F, Füllstand L, Dichte oder Gaskonzentration eines Mediums.

Die mittels der Recheneinheit C ermittelten Cluster, und weitere Analyseergebnisse wie Clusterbänder und/oder die zugehörigen Merkmale der einzelnen Cluster (wie z.B. Mittelwerte, Standardabweichungen oder Autokorrelationen) werden in dem in Fig. 4 skizierten Ausführungsbeispiel in einer weiteren Speichereinheit Sp2 abgelegt. Die Cluster in ihrer jeweiligen graphischen Ausführung können auf der graphischen Benutzeroberfläche einer Anzeigeeinheit B zur Visualisierung ausgegeben werden. An dieser Stelle kann ein Systemnutzer oder Anwender O oder ein Prozessexperte die Cluster kennzeichnen, indem Kommentare oder Metadatendatensätze in einem Eingabefeld der Benutzeroberfläche eingegeben werden. Die Metadaten können wie in dieser Ausführungsvariante gezeigt in einem weiteren Speicher Sp3 abgespeichert werden, welcher mit Sp2, dem Speicher für die Clusterbänder automatisch verknüpft ist. Denkbar ist auch eine Ausführung des Systems, bei welcher der Speicher für die Metadaten bzgl. der Phasen, der Batches des Equipments der Anlage etc. geordnet oder klassifiziert sind. Auch ist eine einzelne Speichereinheit für die Metadaten in Korrelation mit den Clustern oder Clusterbändern denkbar.

Erhält das System S einen Datensatz aus der technischen Anlage TA (zum Beispiel während des laufenden Betriebs der Anlage), wird dieser Datensatz, der Zeitreihendaten eines zu untersuchenden Prozessabschnitts enthält, einer Einheit A übermittelt, in welcher die Zugehörigkeit des neuen Datensatzes zu den bereits in der Einheit C ermittelten Clustern überprüft wird. Alternativ kann die Einheit A auch einen historischen Datensatz aus der Speichereinheit Sp1 mit den historischen multivariaten Daten erhalten. Hierzu sind die Einheiten und Speicher kommunikativ miteinander verbunden. Nach der Clusterzugehörigkeitsprüfung in Einheit A wird an den Anwender O eine Benachrichtigung oder Notifikation gesendet, ob und zu welchem Cluster der neue Datensatz zuzuordnen ist. Die Nachricht wird auf der graphischen Benutzeroberfläche der Anzeigeeinheit B angezeigt.

Die Anzeige- und Bedieneinheit B kann auch direkt an das System anschließbar sein oder je nach Implementierung beispielsweise über einen Datenbus mit dem System verbunden sein. In einer besonders vorteilhaften Ausführungsvariante ist die Anzeigeeinheit Teil des Systems S.

Auf der Benutzeroberfläche der Anzeige- und Bedieneinheit B werden die zu einem Datensatz zugehörigen Cluster angezeigt. Zusätzlich werden die zugehörigen Metadaten angezeigt. Nun kann ein Prozessexperte das Ergebnis überprüfen und die Ursache von Problemen ermitteln. So besteht die Möglichkeit, dass ein Systemnutzer O während der Ursachenanalyse für die aktuell analysierten Cluster Kommentare oder Metadatendatensätze in einem Eingabefeld der Benutzeroberfläche ergänzt. Durch das Speichern dieser Metadaten wird das System im Laufe der Zeit intelligenter und kann als interaktiv-selbstlernendes System betrachtet werden.

Das System S zur Durchführung des erfindungsgemäßen Verfahrens kann beispielsweise auch in einer Client-Server-Architektur realisiert werden. Hierbei dient der Server mit seinen Datenspeichern der Bereitstellung von gewissen Diensten wie dem erfindungsgemäßen System, zur Bearbeitung einer genau definierten Aufgabe (hier die Berechnung der Cluster und die Zuordnung von neuen Datensätzen zu den vorhandenen Clustern). Der Client (hier Einheit B) ist in der Lage, die entsprechenden Dienste vom Server anzufordern und zu nutzen. Typische Server sind Webserver zum Bereitstellen von Web-Seiten-Inhalten, Datenbankserver zum Speichern von Daten oder Anwendungsserver zum Bereitstellen von Programmen. Die Interaktion zwischen dem Server und Client erfolgt über geeignete Kommunikationsprotokolle wie http oder jdbc. Eine weitere Möglichkeit ist der Einsatz des Verfahrens als Applikation in einer Cloud Umgebung (z.B. der Siemens MindSphere), wobei ein oder mehrere Server das erfindungsgemäße System in der Cloud beherbergen. Alternativ kann das System als On-Premise Lösung direkt auf der technischen Anlage implementiert sein, sodass eine lokale Verbindung zu Datenbanken und Rechnern auf der Leitsystemebene möglich ist.

## Patentansprüche

1. Verfahren zur Optimierung eines Produktionsprozesses in einer technischen Anlage, in welcher ein verfahrenstechnischer Prozess mit mindestens einem Prozessschritt abläuft, wobei eine Vielzahl von Datensätzen von Durchläufen (R1, R2, ..., RM) eines Prozessschritts mit Werten von Prozessvariablen zeitabhängig erfasst und in einem Datenspeicher abgelegt werden,
**dadurch gekennzeichnet,**
- **dass** ein zu untersuchender Prozessabschnitt (PA) des verfahrenstechnischen Prozesses ausgewählt wird,
- **dass** für diesen Prozessabschnitt (PA) die zu untersuchenden Prozessvariablen ausgewählt werden,
- **dass** für diesen Prozessabschnitt (PA) und die ausgewählten Prozessvariablen historische Datensätze der zugehörigen Durchläufe ausgewählt werden,
- **dass** die derart erhaltenen Zeitserien mittels eines Machine Learning Verfahrens zu Clustern zusammengefasst werden,
- **dass** die zu den erhaltenen Clustern zugehörigen Zeitserien gemäß ihrer Zugehörigkeit visualisiert werden und die einzelnen Cluster gekennzeichnet und mit Metadaten verknüpft werden, und
- **dass** die gekennzeichneten und mit Metadaten verknüpften Cluster zur Optimierung des Produktionsprozesses verwendet werden.

2. Verfahren nach Anspruch 1,
**dadurch gekennzeichnet,**
- **dass** für mindestens eine Prozessvariable ein neuer Datensatz eines Prozessabschnitts (PA) mittels einer auf das Cluster-Verfahren angepassten Metrik überprüft wird, ob oder wie gut die Werte des Datensatzes einem zuvor gekennzeichneten Cluster zugeordnet werden können und
- **dass** einem Anwender nach der erfolgten Zuordnung des Datensatzes zu einem oder mehreren Clustern zumindest Teile von zuvor mit dem Cluster hinterlegten Metadaten ausgegeben und zusätzlich zur Überwachung des Produktionsprozesses verwendet werden können.

3. Verfahren nach Anspruch 2,
**dadurch gekennzeichnet,**
**dass** die Metrik zur Zuordnung des neuen Datensatzes zu einem Cluster mittels eines Anpassungsfaktors berechnet wird, wobei zunächst die Breite und der Mittelwert eines betrachteten Clusterbandes bestimmt wird, dass pro Zeitstempel des neuen Datensatzes eine skalierte Abweichung (= Distanz zum Mittelwert des Clusterbandes skaliert mit der entsprechenden Bandbreite) bestimmt wird, dass für alle Zeitstempel des neuen Datensatzes die Anzahl und Abweichungsstärke bestimmt wird, die eine bestimmte Größe der skalierten Abweichungen überschreiten und dass die unterschiedlichen Laufzeiten der Zeitserien des Clusters im Vergleich zur Laufzeit des neuen Datensatzes berücksichtigt werden.

4. Verfahren nach Anspruch 3,
**dadurch gekennzeichnet,**
**dass** Ausreißer gefiltert werden, indem die skalierten Abweichungen entlang der Zeitachse geglättet werden.

5. Verfahren nach einem der Ansprüche 2 bis 4,
**dadurch gekennzeichnet,**
**dass** das Verfahren während des laufenden Betriebs der technischen Anlage optional in Echtzeit durchgeführt wird.

6. Verfahren nach einem der Ansprüche 2 bis 5,
**dadurch gekennzeichnet,**
**dass** im laufenden Betrieb die Zuordnung eines neuen Datensatzes zu einem Cluster angestoßen wird, wenn die Laufzeit des neuen Datensatzes mindestens einem vorbestimmten Bruchteil des Medians der Laufzeiten der Zeitserien des Clusters entspricht.

7. Verfahren nach einem der vorhergehenden Ansprüche, **dadurch gekennzeichnet,**
**dass** der Prozessabschnitt gemäß einer Logik oder datengetrieben, insbesondere basierend auf Daten des Produktionsprozesses, ausgewählt wird.

8. Verfahren nach einem der vorhergehenden Ansprüche, **dadurch gekennzeichnet,**
**dass** die Clusterung gemäß statistischen oder datengetrieben berechneten Merkmalen der Zeitserien oder aufgrund der Zeitserien selbst erfolgt.

9. Verwendung des Verfahrens gemäß einem der Ansprüche 1 bis 8 zum Labelling von Gruppen von Datensätzen, insbesondere Zeitreihendaten.

10. Verwendung des Verfahrens gemäß einem der Ansprüche 1 bis 8 zur Ursachenanalyse von auftretenden Problemen beim Produktionsprozess in einer technischen Anlage.

11. System (S) zur Optimierung eines Produktionsprozesses in einer technischen Anlage, in welcher ein verfahrenstechnischer Prozess mit mindestens einem Prozessschritt abläuft, und welches ausgebildet ist, Verfahrensschritte nach einem der Ansprüche 1 bis 8 durchzuführen,
umfassend mindestens:
- eine Einheit (Sp1, Sp2, Sp3) zum Speichern von mindestens: historischen Datensätzen mit Werten von zeitabhängig ermittelten Prozessvariablen, welche einen Durchlauf (R1, R2...) eines Prozessschritts kennzeichnen, oder von den Prozess betreffenden Metadaten oder von Clusterbändern und Merkmalen im Zusammenhang mit ermittelten Clustern ,
- eine Recheneinheit (C) ausgebildet mindestens zur Ermittlung von Clustern mittels eines ML Modells und welche mit der mindestens einen Speichereinheit (Sp1, Sp2, Sp3) verbunden ist,
- eine Einheit (B) zum Anzeigen der ermittelten Cluster und weiterer Analyseergebnisse und zur Kennzeichnung der Cluster mit entsprechenden Metadaten.

12. System (S) nach Anspruch 11,
ferner umfassend eine Einheit (A) zur Überprüfung, ob ein neuer Datensatz eines Prozessabschnitts zu einem zuvor ermittelten Cluster gehört.

13. Computerprogramm, insbesondere Software-Applikation, mit durch einen Computer ausführbaren Programmcodeanweisungen zur Implementierung des Verfahrens nach einem der Ansprüche 1 bis 8, wenn das Computerprogramm auf einem Computer ausgeführt wird.

## Claims

1. Method for optimising a production process in a technical plant, in which a technical process with at least one process step is executed, wherein a plurality of data sets of runs (R1, R2, ..., RM) of a process step with values of process variables are recorded as a function of time and stored in a data memory,
**characterised in that**
- a process stage (PA) of the technical process to be investigated is selected,
- the process variables to be investigated for this process stage (PA) are selected,
- historical data sets of the associated runs for this process stage (PA) and the selected process variables are selected,
- the time series obtained in this way are grouped into clusters using a machine learning method,
- the time series associated with the obtained clusters are displayed according to their associations, and the individual clusters are characterised and linked to metadata, and
- the clusters that are characterised and linked to metadata are used to optimise the production process.

2. Method according to claim 1,
**characterised in that**
- a new data set of a process stage (PA) is checked for at least one process variable using a metric adapted to the cluster method, in order to determine whether or how well the values of the data set can be assigned to a previously characterised cluster and
- after the data set has been assigned to one or more clusters, at least some of the metadata previously stored with the cluster can be displayed for the user and can also be used to monitor the production process.

3. Method according to claim 2,
**characterised in that**
the metric for assigning the new data set to a cluster is calculated using an adaptation factor, wherein initially the width and mean value of an observed cluster ribbon are determined, a scaled deviation (= distance to the mean value of the cluster ribbon scaled by the corresponding bandwidth) is determined per time stamp of the new data set, the quantity and strength of deviation is determined for all time stamps of the new data set, which exceed a specific size of the scaled deviations, and that the various durations of the time series of the cluster are considered in comparison to the duration of the new data set.

4. Method according to claim 3,
**characterised in that**
anomalies are filtered by evening out the scaled deviations along the time axis.

5. Method according to one of claims 2 to 4,
**characterised in that**
the method can optionally be performed in real time during ongoing operation of the technical plant.

6. Method according to one of claims 2 to 5,
**characterised in that**
the assignment of a new data set to a cluster is triggered during ongoing operation if the duration of the new data set corresponds to at least a predefined fraction of the median of the durations of the time series of the cluster.

7. Method according to one of the preceding claims, **characterised in that**
the process stage is selected according to a logic or on a data-driven basis, in particular using data from the production process.

8. Method according to one of the preceding claims, **characterised in that**
clustering is effected according to statistical or data-driven calculated features of the time series or on the basis of the time series themselves.

9. Use of the method according to one of claims 1 to 8 for labelling of groups of data sets, particularly time series data.

10. Use of the method according to one of claims 1 to 8 for cause analysis of problems occurring in the production process in a technical plant.

11. System (S) for optimising a production process in a technical plant, in which a technical process with at least one process step is executed and which is designed to perform method steps according to one of claims 1 to 8,
comprising at least:
- one unit (Sp1, Sp2, Sp3) for storing at least: historical data sets with values of process variables recorded as a function of time, which characterise a run (R1, R2...) of a process step, or metadata pertaining to the process, or cluster ribbons and features related to identified clusters,
- a processing unit (C) designed at least to identify clusters using an ML model and that is connected to the at least one memory unit (Sp1, Sp2, Sp3),
- a unit (B) for displaying the identified clusters and other analysis results and for characterising the clusters with corresponding metadata.

12. System (S) according to claim 11,
further comprising a unit (A) for checking whether a new data set of a process stage belongs to a previously identified cluster.

13. Computer program, particularly a software application, with program code instructions executable by a computer for implementing the method according to one of claims 1 to 8, if the computer program is executed on a computer.

## Revendications

1. Procédé d'optimisation d'une opération de production dans une installation technique, dans lequel se déroule une opération de la technique des procédés ayant au moins un stade opératoire, dans lequel on saisit en fonction du temps une pluralité d'ensembles de données de déroulements (R1, R2, ..., RM) d'un stade opératoire avec des valeurs de variables opératoires et on les archive dans une mémoire de données,
**caractérisé**
- **en ce que** l'on sélectionne un segment (PA) à étudier de l'opération de la technique des procédés,
- **en ce que** pour ce segment (PA) opératoire, on sélectionne les variables opératoires à étudier,
- **en ce que** pour ce segment (PA) opératoire et les variables opératoires sélectionnées, on sélectionne des ensembles de données passés des déroulements leur appartenant,
- **en ce que** l'on rassemble en partitionnements les séries temporelles ainsi obtenues au moyen d'un procédé d'apprentissage automatique,
- **en ce que** l'on visualise suivant leur appartenance les séries temporelles appartenant aux partitionnements obtenus et on caractérise les divers partitionnements et on les combine à des métadonnées, et
- **en ce que** l'on utilise les partitionnements caractérisés et combinés à des métadonnées pour l'optimisation de l'opération de production.

2. Procédé suivant la revendication 1,
**caractérisé**
- **en ce que** pour au moins une variable opératoire, on contrôle un ensemble nouveau de données d'un segment (PA) opératoire, au moyen d'une métrique adaptée au procédé par partitionnement, si avec quelle valeur les valeurs de l'ensemble de données peuvent être affectées à un partitionnement caractérisé précédemment, et
- **en ce que**, après l'affectation effectuée de l'ensemble de données à un ou à plusieurs partitionnements, on peut donner à un utilisateur au moins des parties de métadonnées archivées auparavant avec le partitionnement et les utiliser supplémentairement pour le contrôle de l'opération de production.

3. Procédé suivant la revendication 2,
**caractérisé**
**en ce que** l'on calcule la métrique d'affectation de l'ensemble nouveau de données à un partitionnement au moyen d'un facteur d'adaptation, dans lequel on détermine d'abord la largeur et la valeur moyenne d'une bande de partitionnement considérée, en ce que, par horodatage de l'ensemble nouveau de données, on détermine un écart mis à l'échelle (= distance à la valeur moyenne de la bande de partitionnement, avec la largeur de bande correspondante), en ce que l'on détermine, pour tous les horodatages de l'ensemble nouveau de données, le nombre et l'intensité de l'écart, qui dépassent une grandeur déterminée des écarts mis à l'échelle et en ce que l'on prend en compte les temps d'exécution différents des séries temporelles du partitionnement par rapport aux temps d'exécution du nouvel ensemble de données.

4. Procédé suivant la revendication 3,
**caractérisé**
**en ce que** l'on filtre des aberrations en lissant les écarts mis à l'échelle suivant l'axe des temps.

5. Procédé suivant l'une des revendications 2 à 4, **caractérisé**
**en ce que** l'on effectue éventuellement en temps réel le procédé pendant le fonctionnement en cours de l'installation technique.

6. Procédé suivant l'une des revendications 2 à 5, **caractérisé**
**en ce que** dans le fonctionnement en cours, on ébranle l'affectation d'un ensemble nouveau de données à un partitionnement, si le temps d'exécution de l'ensemble nouveau de données correspond au moins à une fraction déterminée à l'avance de la médiane des temps d'exécution de la série temporelle du partitionnement.

7. Procédé suivant l'une des revendications précédentes, **caractérisé**
**en ce que** l'on sélectionne le segment opératoire suivant une logique ou suivant des données, en particulier en se fondant sur des données de l'opération de production.

8. Procédé suivant l'une des revendications précédentes, **caractérisé**
**en ce que** le partitionnement s'effectue soi-même suivant des caractéristiques, statistiques ou calculées en fonction des données, des séries temporelles ou sur la base des séries temporelles.

9. Utilisation du procédé suivant l'une des revendications 1 à 8 pour le labelling de groupes d'ensembles de données, en particulier de données de séries temporelles.

10. Utilisation du procédé suivant l'une des revendications 1 à 8, pour l'analyse des causes de problèmes apparaissant, lors de l'opération de production dans une installation technique.

11. Système (S) d'optimisation d'une opération de production dans une installation technique, dans lequel une opération de la technique des procédés se déroule avec au moins un stade opératoire, et qui est constitué pour effectuer des stades de procédé suivant l'une des revendications 1 à 8, comprenant au moins :
- une unité (Sp1, Sp2, Sp3) de mise en mémoire d'au moins : des ensembles de données passés ayant des valeurs de variables opératoires établies en fonction du temps, qui caractérisent un déroulement (R1, R2, ...) d'un stade opératoire, ou des métadonnées concernant l'opération ou des bandes de partitionnement et des caractéristiques en relation avec des partitionnements déterminés,
- une unité (C) informatique, constituée au moins pour l'établissement de partitionnements au moyen d'un modèle ML, et qui est reliée à la au moins une unité (Sp1, Sp2, Sp3) de mémoire,
- une unité (B) d'affichage des partitionnements établis et d'autres résultats d'analyse et de caractérisation des partitionnements par des métadonnées correspondantes.

12. Système (S) suivant la revendication 11,
comprenant en outre une unité (A) de contrôle du point de savoir, si un ensemble nouveau de données d'un segment opératoire appartient à un partitionnement établi précédemment.

13. Programme d'ordinateur, en particulier application logicielle, comprenant des instructions de code de programme pouvant être exécutées par ordinateur pour la mise en œuvre du procédé suivant l'une des revendications 1 à 8, lorsque le programme d'ordinateur est exécuté sur un ordinateur.
